# EUROPEAN PATENT APPLICATION

(11) **EP 4 763 825 A1**
(43) Date of publication of application: **24.06.2026**
(21) Application number: 25189133.9
(22) Date of filing: 11.07.2025
(51) Int. Cl.: C04B 37/00, C04B 38/00

(54) **OFFSET BOND LINE FOR REDUCED INTERNAL CHANNELED REACTION BONDED CERAMICS**

(30) Priority: 17.12.2024 US 202418983920
(71) Applicant: II-VI Delaware, Inc., Wilmington, DE 19890 (US)
(72) Inventor: DENNENY, Kevin, Wilmington, 19890 (US); SALAMONE, Samuel, Wilmington, 19890 (US); MCANANY, Sean, Wilmington, 19890 (US)
(74) Representative: Schmidt, Christian

(57) **Abstract**

Embodiments of the present disclosure may include a reaction-bonded ceramics device, the device including a first half including a first surface and a second half including a second surface. A plurality of cavities may be formed between the first surface and the second surface when the first half abuts the second half. The plurality of cavities may include a conveyance duct and an adjacent glue duct.

## Description

### TECHNICAL FIELD

The present disclosure generally relates to offset bond line for reduced internal channeled reaction bonded ceramics and its fabrication method.

### BACKGROUND

Aspects of the present disclosure relate to offset bond line for reduced internal channeled reaction bonded ceramics. In this regard, conventional internal channeled reaction bonded ceramics may be costly, cumbersome, and/or inefficient.

Limitations and disadvantages of conventional systems and methods will become apparent to one of skill in the art, through comparison of such approaches with some aspects of the present methods and systems set forth in the remainder of this disclosure with reference to the drawings.

### BRIEF SUMMARY OF THE DISCLOSURE

Shown in and/or described in connection with at least one of the figures, and set forth more completely in the claims are offset bond line for reduced internal channeled reaction bonded ceramics.

These and other advantages, aspects and novel features of the present disclosure, as well as details of illustrated embodiments thereof, will be more fully understood from the following description and drawings.

### BRIEF DESCRIPTION OF THE DRAWINGS

The various features and advantages of the present disclosure may be more readily understood with reference to the following detailed description taken in conjunction with the accompanying drawings, wherein like reference numerals designate like structural elements.
FIG. 1 is a cross-section of a conventional internal channel reaction-bonded ceramics device.
FIG. 2 is a block diagram illustrating a reaction-bonded ceramics device, according to some embodiments of the present disclosure.
FIG. 3 is a flowchart illustrating a method, according to some embodiments of the present disclosure.
FIG. 4 is a cross-section illustrating a reaction bonded ceramics device according to some embodiments of the present disclosure.
FIG. 5 shows a cross section of an exemplary reaction bonded ceramics device according to some embodiments of the present disclosure.

### DETAILED DESCRIPTION

The following discussion provides various examples of offset bond line for reduced internal channeled reaction bonded ceramics. Such examples are non-limiting, and the scope of the appended claims should not be limited to the particular examples disclosed. In the following discussion, the terms "example" and "e.g.," are non-limiting.

The figures illustrate the general manner of construction, and descriptions and details of well-known features and techniques may be omitted to avoid unnecessarily obscuring the present disclosure. In addition, elements in the drawing figures are not necessarily drawn to scale. For example, the dimensions of some of the elements in the figures may be exaggerated relative to other elements to help improve understanding of the examples discussed in the present disclosure. The same reference numerals in different figures denote the same elements.

The term "or" means any one or more of the items in the list joined by "or". As an example, "x or y" means any element of the three-element set {(x), (y), (x, y)}. As another example, "x, y, or z" means any element of the seven-element set {(x), (y), (z), (x, y), (x, z), (y, z), (x, y, z)}.

The terms "comprises," "comprising," "comprises," and/or "comprising," are "open ended" terms and specify the presence of stated features, but do not preclude the presence or addition of one or more other features.

The terms "first," "second," etc. may be used herein to describe various elements, and these elements should not be limited by these terms. These terms are only used to distinguish one element from another. Thus, for example, a first element discussed in this disclosure could be termed a second element without departing from the teachings of the present disclosure.

Unless specified otherwise, the term "coupled" may be used to describe two elements directly contacting each other or describe two elements indirectly connected by one or more other elements. For example, if element A is coupled to element B, then element A can be directly contacting element B or indirectly connected to element B by an intervening element C. Similarly, the terms "over" or "on" may be used to describe two elements directly contacting each other or describe two elements indirectly connected by one or more other elements.

Many reaction-bonded silicon carbide (RB-SiC) ceramic components for the semiconductor capital equipment industry contain internal channels. Examples are water-cooled wafer tables, water-cooled collector mirrors, and water-cooled high-energy laser mirrors. The ceramic parts may be formed by two preform halves with channels, bonding the preform halves with silicon carbide-based glue (a caulk-like material) and ceramic firing to yield a one-piece ceramic body with internal channels.

During the preform bonding operation, a bead of excess glue may exude into the channel. With large channel sizes, this is not an issue. However, many next generation designs use ultra-small channel sizes (e.g., less than 1 mm). A bead of excess glue may clog channels of such a small size, potentially impact flow and impact the volume available. An alternative bonding method may be advantageous.

The present disclosure provides for an offset bond-line from the channel/duct to avoid excess glue from exuding into the channel. The channels may be machined in the preforms, so that cavities may be formed upon assembly.

Embodiments of the present disclosure may comprise a reaction-bonded ceramics device, the device comprising a first half comprising a first surface. Embodiments may also comprise a second half comprising a second surface. In some embodiments, the first half and the second half may be configured to form a matching pair of halves.

Embodiments may also comprise a plurality of cavities, formed between the first surface and the second surface when the first half abuts the second half, and the plurality of cavities may comprise a conveyance duct and an adjacent glue duct. In some embodiments, the conveyance duct may comprise a first conveyance duct surface formed by the first surface. Embodiments may also comprise a second conveyance duct surface formed by the second surface. In some embodiments, the glue duct may comprise a first glue duct surface formed by the first surface. Embodiments may also comprise a second glue duct surface formed by the second surface. Embodiments may also comprise glue. In some embodiments, the glue may be operable to bond the first half to the second half. In some embodiments, the glue partly fills the glue duct.

In some embodiments, the first half and the second half may be made from reaction-bonded silicon carbide. In some embodiments, the conveyance duct may be operable to convey a liquid or a gas. In some embodiments, the first surface and/or the second surface may be formed by a protrusion or a recess. In some embodiments, the glue may comprise silicon carbide and optionally carbon-based additives.

In some embodiments, the first half may be a body and the second half may be a cover. In some embodiments, the conveyance duct cross-section has a height or width of less than 1 mm. In some embodiments, none of the glue is in the conveyance duct. In some embodiments, the conveyance duct may be operable for cooling.

Embodiments of the present disclosure may also comprise a method to manufacture a reaction-bonded ceramics device, the method comprising take a first half comprising a first surface and a second half comprising a second surface. In some embodiments, the first half and the second half may be configured to form a matching pair of halves.

Embodiments may also comprise abutting the first half onto the second half to form a plurality of cavities between the first surface and the second surface. In some embodiments, the plurality of cavities may comprise a conveyance duct and an adjacent glue duct. In some embodiments, the conveyance duct may comprise a first conveyance duct surface formed by the first surface, and a second conveyance duct surface formed by the second surface.

Embodiments may also comprise bonding the first half to the second half using glue. In some embodiments, the glue partly fills the glue duct.

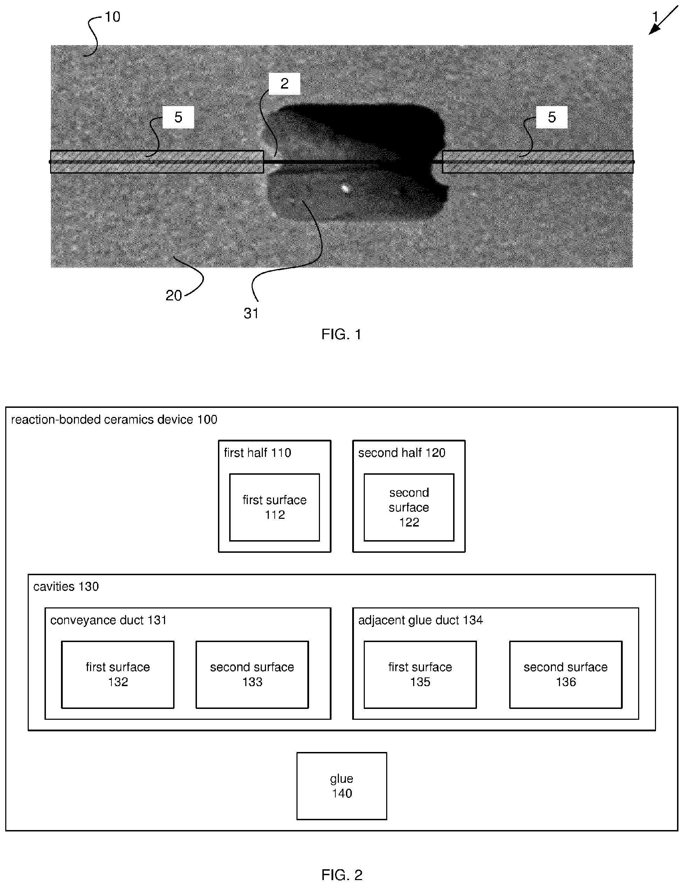

Referring now to FIG. 1, FIG. 1 is a cross-section of a conventional internal channel reaction-bonded ceramics device. There is shown a ceramics device 1 comprising a first half 10, a second half 20, a duct 31, bonding zones 5, and exuded glue 2. Such an approach is particularly useful to form internal cavities that may serve as internal channels. Internal channels may be useful, for example, to form ducts that may carry cooling liquids or cooling gases. Internal ducts or channels may be used for water-cooled wafer tables, water-cooled collector mirrors, and water-cooled high-energy laser mirrors.

In some instances, reaction bonded silicon carbide (RB-SiC) devices are formed from bonding together two halves. The two halves may be first half 10 and second half 20. The halves may also be referred to as preforms. In FIG. 1, a cavity is formed between the first half 10 and the second half 20, i.e., duct 31.

The preforms may be bonded with silicon carbide based glue, which is typically a caulk-like mixture of silicon carbide particles and carbon-based additives. After firing, the preform halves are bonded through the solidified glue to yield a one-piece ceramic body with internal channels, an example of which is shown in FIG. 1.

To prevent gaps in the bond line, ample glue is applied to the interface between the two halves. However, this excess glue 2 may exude into the duct 31, forming a glue bead 2. The glue bead 2 may affect flow characteristics and impact that duct volume when the duct 31 is very small. A duct may also be referred to as a channel, a tunnel, a cavity, a well, a conduit, a canal, a tube, or a culvert. Thus, it may be desirable to place the glue in a location farther removed from the duct 31, so that glue may not exude into the channel.

FIG. 2 is a block diagram that describes a reaction-bonded ceramics device 100, according to some embodiments of the present disclosure. In some embodiments, the reaction-bonded ceramics device 100 may comprise a first half 110, a second half 120, and glue 140. The reaction-bonded ceramics device 100 may also comprise a plurality of cavities 130, formed between the first surface 112 and the second surface 122 when the first half 110 abuts the second half 120. The first half 110 may comprise a first surface 112. The second half 120 may comprise a second surface 122.

In some embodiments, the first half 110 and the second half 120 may be configured to form a matching pair of halves. The plurality of cavities 130 may comprise a conveyance duct 131 and an adjacent glue duct 134. The conveyance duct 131 may comprise a first conveyance duct surface 132 formed by the first surface 112 and a second conveyance duct surface 133 formed by the second surface 122. The adjacent glue duct 134 may comprise a first glue duct surface 135 formed by the first surface 112 and a second glue duct surface 136 formed by the second surface 122. The glue 140 may be operable to bond the first half 110 to the second half 120. The glue 140 partly fills the glue duct 134.

In some embodiments, the first half 110 and the second half 120 may be made from reaction-bonded silicon carbide. In some embodiments, the conveyance duct 131 may be operable to convey a liquid or a gas. In some embodiments, the first surface 112 and/or the second surface 122 may be formed by a protrusion or a recess. In some embodiments, the glue may comprise silicon carbide and optionally carbon-based additives. In some embodiments, the first half 110 may be a body and the second half 120 may be a cover. In some embodiments, none of the volume of the glue 140 may be in the conveyance duct 131. In some embodiments, the conveyance duct 131 may be operable for cooling.

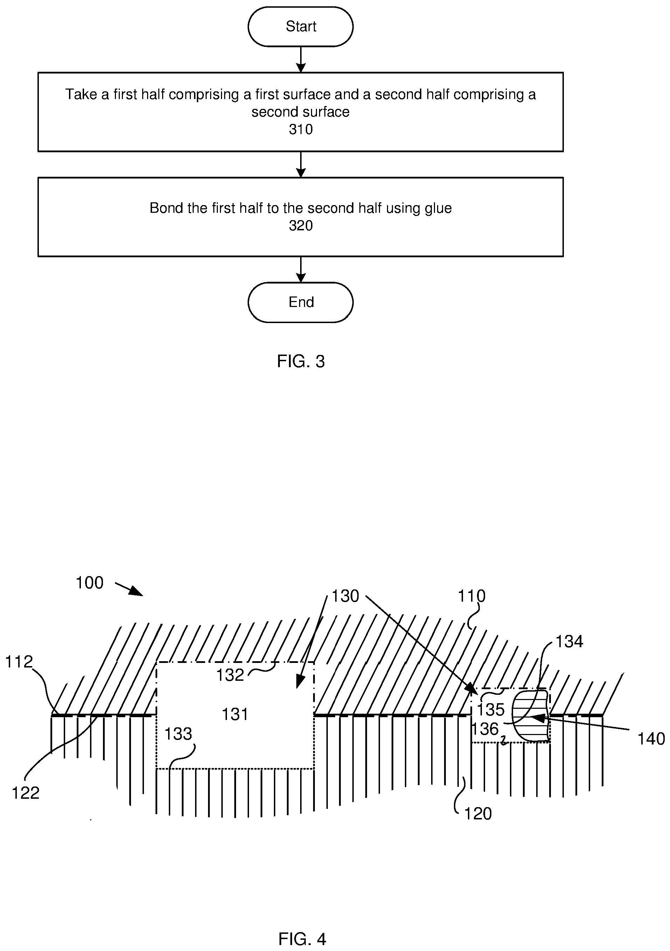

FIG. 3 is a flowchart that describes a method, according to some embodiments of the present disclosure. In some embodiments, at 310, the method may comprise taking a first half comprising a first surface and a second half comprising a second surface. At 320, the method may comprise bonding the first half to the second half using glue. The first half and the second half may be configured to form a matching pair of halves. The method may further comprise abutting the first half onto the second half to form a plurality of cavities between the first surface and the second surface.

FIG. 4 is a cross-section illustrating a reaction bonded ceramics device according to some embodiments of the present disclosure. The reaction-bonded ceramics device 100 may comprise a first half 110 (slanted pattern fill), a second half 120 (vertical-lines pattern fill), and glue 140 (horizontal-lines pattern fill). The reaction-bonded ceramics device 100 may also comprise a plurality of cavities 130 (ducts 131, 134), formed between the first surface 112 (solid line) and the second surface 122 (dash-dash line) when the first half 110 abuts the second half 120. The first half 110 may comprise a first surface 112. The second half 120 may comprise a second surface 122.

In some embodiments, the first half 110 and the second half 120 may be configured to form a matching pair of halves. The plurality of cavities 130 may comprise a conveyance duct 131 and an adjacent glue duct 134. The conveyance duct 131 may comprise a first conveyance duct surface 132 formed by the first surface 112 and a second conveyance duct surface 133 formed by the second surface 122. The adjacent glue duct 134 may comprise a first glue duct surface 135 formed by the first surface 112 and a second glue duct surface 136 formed by the second surface 122. The glue 140 may be operable to bond the first half 110 to the second half 120. The glue 140 partly fills the glue duct 134.

By placing a separate glue duct 134 close to a conveyance duct 131 and configuring the glue duct 134 to be of a larger volume than the volume of glue 140, the glue 140 can be wholly contained within the glue duct 134 and does not exude into the conveyance duct 131.

In some embodiments, the conveyance duct 131 may be operable to convey a liquid or a gas. Because no glue exudes into the conveyance duct 131, the flow may be unimpeded and the volume is not affected.

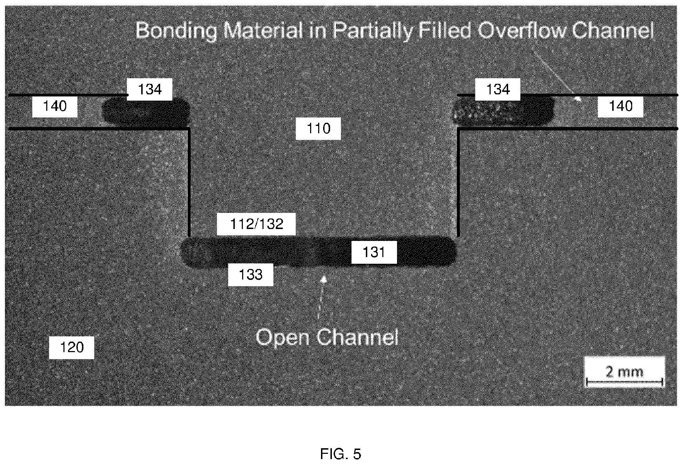

FIG. 5 shows a cross section of an exemplary reaction bonded ceramics device according to some embodiments of the present disclosure. In this figure, the first half 110 comprising the first surface 112 may form a protrusion. The second half 120 comprising a second surface 122 may form a matching recess. An interlocking design as shown may be advantageous for assembly and may provide good separation between a conveyance duct 131 and a glue duct 134 at a small horizontal separation. An interlocking design may be desirable to further reduce the risk of glue exuding into the conveyance channel 131.

In accordance with various embodiments, two glue ducts 134 are shown. Glue 140 may be seen to partly fill the two glue ducts 134. It may be observed that there is no glue present in the conveyance duct 131.

The present disclosure comprises reference to certain examples; however, it will be understood by those skilled in the art that various changes may be made and equivalents may be substituted without departing from the scope of the disclosure. In addition, modifications may be made to the disclosed examples without departing from the scope of the present disclosure. Therefore, it is intended that the present disclosure not be limited to the examples disclosed, but that the disclosure will comprise all examples falling within the scope of the appended claims.

## Claims

1. A reaction-bonded ceramics device, said device comprising:
a first half comprising a first surface;
a second half comprising a second surface; wherein said first half and said second half are configured to form a matching pair of halves;
a plurality of cavities, formed between said first surface and said second surface when said first half abuts said second half, and said plurality of cavities comprises
a conveyance duct; and
an adjacent glue duct;
wherein said conveyance duct comprises a first conveyance duct surface formed by said first surface, and a second conveyance duct surface formed by said second surface;
wherein said glue duct comprises a first glue duct surface formed by said first surface, and a second glue duct surface formed by said second surface;
glue, wherein said glue is operable to bond said first half to said second half, and wherein said glue partly fills said glue duct.

2. The device of claim 1, wherein said first half and said second half are made from reaction-bonded silicon carbide.

3. The device of claim 1, wherein said conveyance duct is operable to convey a liquid or a gas.

4. The device of claim 1, wherein said first surface and/or said second surface may be formed by a protrusion or a recess.

5. The device of claim 1, wherein said glue comprises silicon carbide and optionally carbon-based additives.

6. The device of claim 1, wherein said first half is a body and said second half is a cover.

7. The device of claim 1, wherein said conveyance duct cross-section has a height or width of less than 1 mm.

8. The device of claim 1, wherein none of the volume of said glue is in said conveyance duct.

9. The device of claim 1, wherein said conveyance duct is operable for cooling.

10. A method to manufacture a reaction-bonded ceramics device, said method comprising:
taking a first half comprising a first surface and a second half comprising a second surface; wherein said first half and said second half are configured to form a matching pair of halves;
abutting said first half onto said second half to form a plurality of cavities between said first surface and said second surface, wherein said plurality of cavities comprises a conveyance duct and an adjacent glue duct;
wherein said conveyance duct comprises a first conveyance duct surface formed by said first surface, and a second conveyance duct surface formed by said second surface;
wherein said glue duct comprises a first glue duct surface formed by said first surface, and a second glue duct surface formed by said second surface;
bonding said first half to said second half using glue, and wherein said glue partly fills said glue duct.

11. The method of claim 10, wherein said first half and said second half are made from reaction-bonded silicon carbide.

12. The method of claim 10, wherein said conveyance duct is operable to convey a liquid or a gas.

13. The method of claim 10, wherein said first surface and/or said second surface may be formed by a protrusion or a recess.

14. The method of claim 10, wherein said glue comprises silicon carbide and optionally carbon-based additives.

15. The method of claim 10, wherein said first half is a body and said second half is a cover.

16. The method of claim 10, wherein said conveyance duct cross-section has a height or width of less than 1 mm.

17. The method of claim 10, wherein none of the volume of said glue is in said conveyance duct.

18. The method of claim 10, wherein said conveyance duct is operable for cooling.
